# DEMANDE DE BREVET EUROPEEN

(11) **EP 1 455 195 A1**
(43) Date de publication de la demande: **08.09.2004**
(21) Numéro de dépôt: 04290561.2
(22) Date de dépôt: 02.03.2004
(51) Int. Cl.: G01R 31/36

(54) **Dispositif et procédé perfectionnées de contrôle de tension de générateurs électrochimiques de batterie rechargeable**

(30) Priorité: 04.03.2003 FR 0302605
(71) Demandeur: SAFT, Société Anonyme, 93170 Bagnolet (FR)
(72) Inventeur: Petitdidier, Xavier, 86000 Poitiers (FR)
(74) Mandataire: Cabinet Hirsch

(57) **Abrégé**

Un dispositif (D) est dédié au contrôle de la tension d'une batterie (BAT) comportant au moins deux modules (Mi), montés en série, comprenant chacun au moins un générateur électrochimique (Gi) et couplés à des moyens d'équilibrage de tension (EEi). Le dispositif (D) comprend des moyens de mesure (Ri,EMi) chargés de déterminer des premières tensions aux bornes de chacun des modules (Mi), des moyens de calcul (MC) chargés de mesurer une seconde tension aux bornes de la batterie (BAT) et de déterminer une tension moyenne par module, représentative de la seconde tension divisée par le nombre de modules (Mi), et des moyens de traitement (ETi) chargés de comparer chaque première tension mesurée à la tension moyenne par module, puis de délivrer aux moyens d'équilibrage (EEi) des signaux représentatifs du résultat d'une comparaison chaque fois que la première tension d'un module est supérieure à la tension moyenne, de sorte qu'ils réduisent la tension aux bornes de ce module (Mi).

## Description

L'invention concerne le domaine des batteries de générateurs électrochimiques, et plus particulièrement celui des dispositifs chargés de contrôler la tension des générateurs électrochimiques qui équipent certaines batteries rechargeables.

Comme le sait l'homme de l'art, la tension mesurée aux bornes d'une batterie dépend de l'état de charge des générateurs électrochimiques (ou générateurs secondaires ou rechargeables, ou encore accumulateurs) qui en constituent les modules. L'état de charge des générateurs électrochimiques fait donc l'objet d'une surveillance permanente par des dispositifs de contrôle de tension. Plus précisément, ces dispositifs sont destinés à éviter que les générateurs électrochimiques ne fassent l'objet de surcharges ou de fortes décharges qui réduisent les performances de la batterie mais surtout en limitent la durée de vie.

C'est notamment le cas du dispositif de contrôle de tension décrit dans le document brevet EP-0 691 725. Ce dispositif comporte n - 1 régulateurs associés à n modules de batterie montés en série. Plus précisément, chaque régulateur est associé à une paire de modules successifs et comprend, d'une part, un comparateur de tension chargé de confronter les valeurs des tensions mesurées aux bornes de chaque module de la paire, et d'autre part, un circuit d'équilibrage chargé de dériver une partie du courant qui circule dans le module présentant la tension la plus élevée vers celui présentant la tension la moins élevée, de sorte que leurs tensions respectives deviennent sensiblement égales.

Un tel mode de fonctionnement offre un réel avantage par rapport à certains autres dispositifs connus, du fait qu'il permet de limiter les écarts de tension entre modules successifs. Mais, il peut induire, dans certaines circonstances, un cumul des décalages (ou « offsets ») des différents comparateurs, susceptible d'engendrer un écart maximal d'équilibrage de tension entre modules égal à (n - 1) fois ledit décalage. Par conséquent, ce dispositif antérieur ne peut convenir qu'aux batteries comportant un faible nombre de modules montés en série, typiquement inférieur à huit (au-delà de ce nombre il survient généralement une dégradation des performances).

Les autres dispositifs de l'art antérieur présentent le même inconvénient que celui mentionné ci-avant et/ou d'autres inconvénients, comme par exemple le coût, ou la complexité, ou encore la consommation électrique.

Aucun dispositif de l'art antérieur n'apportant une entière satisfaction, l'invention a donc pour but d'améliorer la situation.

Elle propose à cet effet un dispositif de contrôle de la tension d'une batterie comportant au moins deux modules montés en série, comprenant chacun au moins un générateur électrochimique et couplés à des moyens d'équilibrage de tension. Ce dispositif se caractérise par le fait qu'il comprend :
des moyens de mesure chargés de déterminer des premières tensions aux bornes de chacun des modules de la batterie,
des moyens de calcul chargés de mesurer une seconde tension aux bornes de la batterie et de déterminer une tension moyenne par module, représentative de la seconde tension divisée par le nombre total de modules,
des moyens de traitement agencés de manière à comparer chaque première tension mesurée à la tension moyenne par module et à adresser aux moyens d'équilibrage des signaux d'alerte, représentatifs du résultat de la comparaison chaque fois que la première tension d'un module est supérieure à la tension moyenne, de sorte qu'ils réduisent la tension aux bornes de ce module.

L'équilibrage reposant désormais sur des comparaisons indépendantes les unes des autres, l'écart maximal d'équilibrage de tension entre modules est au plus égal au décalage de tension des moyens de comparaison.

Le dispositif de contrôle selon l'invention peut comporter d'autres caractéristiques qui pourront être prises séparément ou en combinaison, et notamment :
des moyens de traitement agencés de manière à déterminer une donnée représentative de l'écart entre une première tension mesurée et la tension moyenne par module et à adjoindre cette donnée aux signaux. Dans ce cas, les moyens de traitement adressent aux moyens d'équilibrage des signaux d'alerte comportant la donnée d'écart de sorte qu'ils réduisent la tension aux bornes du module concerné d'une valeur représentative de l'écart reçu,
la tension moyenne par module, qui est délivrée par les moyens de calcul, peut être égale à la somme du rapport entre la seconde tension et le nombre total de modules et d'une valeur seuil de décalage,
des moyens de calcul comprenant un ensemble de résistances montées en série et en nombre égal au nombre de modules, ledit ensemble étant raccordé aux bornes de la batterie. Lorsque les modules sont identiques, les résistances sont également identiques,
des moyens de traitement agencés sous la forme d'éléments de traitement associés chacun à un module et chargés, chacun, de comparer la première tension, mesurée aux bornes du module associé, à la tension moyenne par module et de délivrer des signaux d'alerte représentatifs du résultat de la comparaison au moins chaque fois que la première tension est supérieure à la tension moyenne,
des moyens d'équilibrage, éventuellement agencés sous la forme d'éléments d'équilibrage associés chacun à un module. Ces moyens d'équilibrage sont préférentiellement agencés de manière à assurer l'équilibrage des modules en phase de charge et/ou en phase de décharge et/ou en phase de repos,
lorsque les moyens de traitement et les moyens d'équilibrage sont respectivement agencés sous la forme d'éléments de traitement et d'éléments d'équilibrage associés aux différents modules, ils peuvent constituer des circuits de contrôle associés aux différents modules et indépendants les uns des autres.

L'invention concerne également une batterie comportant au moins deux modules de générateur(s) électrochimique(s) montés en série, comprenant chacun au moins un générateur électrochimique, et couplés à un dispositif de contrôle du type de celui présenté ci-avant.

Par ailleurs, l'invention est particulièrement adaptée aux batteries dont les générateurs électrochimiques sont choisis dans un groupe comprenant au moins les générateurs au lithium, comme par exemple les générateurs lithium/ion (Li/Ion), les générateurs argent / zinc et les générateurs à polymères. Mais, d'une manière générale, l'invention s'applique à toutes les batteries dans lesquelles les différents générateurs électrochimiques doivent présenter sensiblement la même tension en leurs bornes afin que les performances soient optimales.

L'invention concerne également un procédé de contrôle de la tension d'une batterie comportant au moins deux modules montés en série et comprenant chacun au moins un générateur électrochimique.

Ce procédé se caractérise par le fait qu'il consiste, d'une première part, à déterminer des premières tensions aux bornes de chacun des modules, d'une deuxième part, à mesurer une seconde tension aux bornes de la batterie, puis à déterminer une tension moyenne par module, représentative de la seconde tension divisée par le nombre de modules, d'une troisième part, à comparer chaque première tension mesurée à la tension moyenne par module et à délivrer des signaux représentatifs du résultat d'une comparaison chaque fois qu'une première tension est supérieure à la tension moyenne, et d'une quatrième part, à réception de signaux désignant un module, à réduire la tension aux bornes du module concerné.

D'autres caractéristiques et avantages de l'invention apparaîtront à l'examen de la description détaillée ci-après, et des dessins annexés, sur lesquels :
la figure 1 illustre de façon schématique un exemple de réalisation d'une batterie rechargeable équipée d'un dispositif de contrôle selon l'invention, et
la figure 2 détaille schématiquement un exemple de réalisation d'un circuit de contrôle d'un dispositif de contrôle selon l'invention.

Les dessins annexés pourront non seulement servir à compléter l'invention, mais aussi contribuer à sa définition, le cas échéant.

L'invention porte sur le contrôle de la tension d'une batterie rechargeable comportant au moins deux modules montés en série et comprenant chacun au moins un générateur électrochimique.

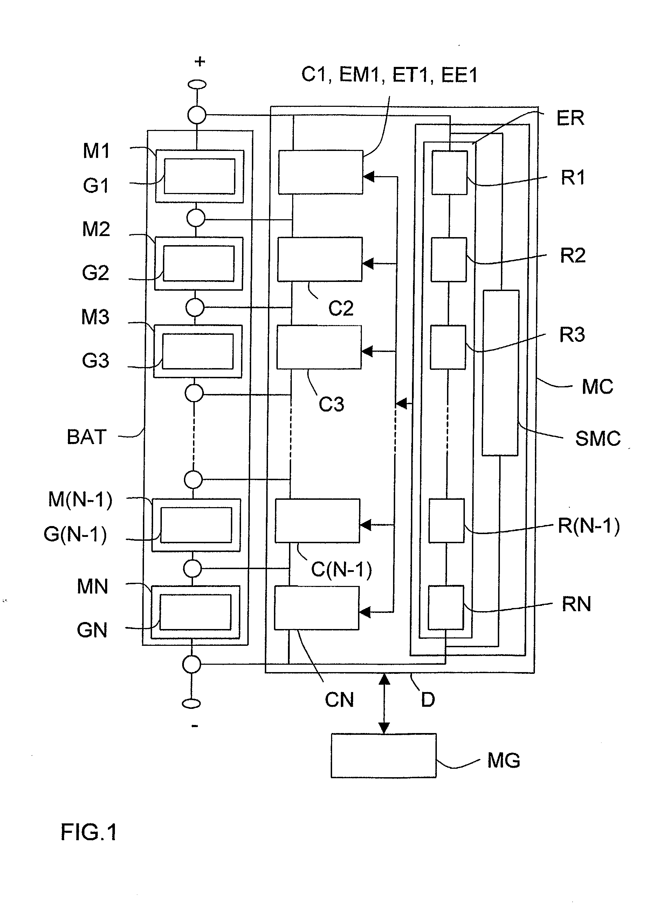

Dans l'exemple illustré sur la figure 1, la batterie rechargeable BAT comprend des modules Mi (ici i= 1 à N, N étant au moins égal à deux ; par exemple N = 15) comportant chacun un générateur électrochimique Gi, comme par exemple un générateur rechargeable de type lithium/ion (Li-ion). Mais l'invention s'applique également aux batteries dont les modules Mi comprennent plusieurs générateurs électrochimiques Gij, montés en série et/ou en parallèle. Par ailleurs, l'invention s'applique également à d'autres types de générateur électrochimique que ceux au lithium, et notamment aux générateurs argent/zinc et aux générateurs à polymères, et d'une manière générale elle s'applique à toutes les batteries dans lesquelles les différents générateurs électrochimiques doivent présenter sensiblement la même tension en leurs bornes de sorte que leurs performances soient optimales.

Le contrôle de la tension de la batterie BAT est assuré par un dispositif de contrôle D dédié. Ce dispositif D comprend préférentiellement autant de circuits de contrôle Ci que de modules Mi, ainsi qu'un module de calcul MC couplé aux différents circuits de contrôle Ci.

Le module de calcul MC est monté, en parallèle, aux bornes (+ et -) de la batterie BAT. Il comprend de préférence un ensemble ER de résistances Ri montées en série et en nombre égal au nombre N de modules Mi, cet ensemble ER étant raccordé aux bornes (+ et -) de la batterie BAT. Lorsque les modules Mi sont identiques, les N résistances Mi sont toutes identiques. En fait, il est préférable de prévoir autant de résistances qu'il y a de générateurs électrochimiques.

Le module de calcul MC comprend également un sous-module de calcul SMC raccordé aux bornes de l'ensemble de résistances ER et donc aux bornes (+ et -) de la batterie BAT. Ce sous-module de calcul SMC est chargé de mesurer la tension U_{BAT} aux bornes de la batterie BAT et de déterminer une tension moyenne par module U_{M}, représentative de la valeur du rapport entre la tension de la batterie U_{BAT} et le nombre total N de modules Mi.

Dans certaines situations, il peut s'avérer préférable de délivrer une tension moyenne par module U_{M} égale à la somme du rapport entre la tension de la batterie U_{BAT} et le nombre total N de modules Mi? et d'une valeur seuil de décalage. Cela permet en effet de tolérer des petits écarts de tension inférieurs ou égaux au décalage choisi, et par conséquent d'éviter un emballement du contrôle de tension. Le seuil de décalage permet en effet d'arrêter la décharge du générateur électrochimique Gi avant que sa tension n'atteigne celle du générateur électrochimique G(j) présentant la tension la plus basse, quelle que soit sa position dans la batterie BAT.

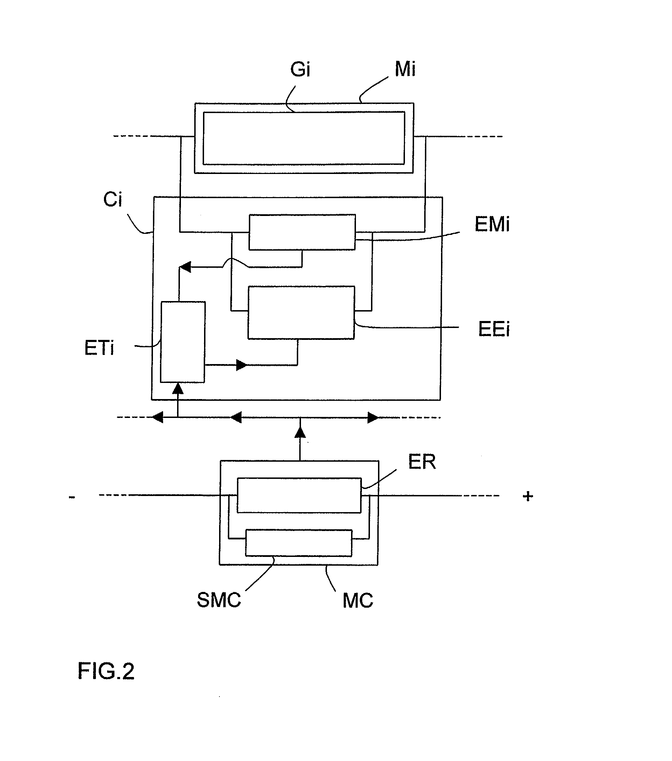

Comme cela est mieux illustré sur la figure 2, chaque circuit de contrôle Ci est monté, en parallèle, aux bornes de l'un des modules Mi. Il comporte tout d'abord un élément de mesure EMi monté, en parallèle, aux bornes de l'un des modules Mi et chargé de mesurer la (première) tension U_{Mod} aux bornes dudit module Mi.

Le circuit de contrôle Ci comprend également un élément de traitement ETi chargé, d'une première part, de comparer la tension de module mesurée U_{Mod}, délivrée par l'élément de mesure EMi associé, à la tension moyenne par module U_{M}, délivrée par le module de calcul MC, d'une deuxième part, de délivrer des signaux d'alerte représentatifs du résultat de sa comparaison chaque fois que la tension U_{Mod} est supérieure à la tension moyenne par module U_{M}, et d'une troisième part, d'adresser à des moyens d'équilibrage ces signaux d'alerte, de sorte qu'ils réduisent la tension aux bornes du module Mi.

La comparaison peut être effectuée, par exemple, à l'aide d'un circuit à amplificateur opérationnel alimenté en tensions U_{Mod} et U_{M}, respectivement par l'élément de mesure EMi et le module de calcul MC.

Préférentiellement, et comme illustré sur la figure 2, les moyens d'équilibrage sont réalisés sous la forme de N éléments d'équilibrage (ou « balancing ») EEi associés chacun à l'un des modules Mi et intégrés chacun au circuit de contrôle Ci correspondant. L'élément d'équilibrage EEi est monté, en parallèle, aux bornes du module associé Mi. Il est chargé de dériver (ou dévier) une partie du courant qui circule dans le module Mi associé ou de le « consommer » de sorte que la tension à ses bornes devienne sensiblement égale à la tension moyenne par module U_{M}. En fait, il doit décharger le module Mi auquel il est couplé de sorte que sa tension (et donc la tension moyenne par module U_{M}) tende le plus vite possible vers la tension de module U_{Mod} qui est la plus faible. En variante, l'élément d'équilibrage EEi peut adresser un ordre à un module externe chargé de l'obtention d'un courant régulé ou plus élevé.

Ainsi, lorsque l'un des générateurs électrochimiques Gi (par exemple le troisième G3) présente une tension à ses bornes égale à 3,6 V, alors que les tensions aux bornes des autres générateurs Gi (i 3) sont égales à 3,7 V, les éléments de traitement ETi (i 3) ordonnent aux éléments d'équilibrage EEi (i 3), auxquels ils sont respectivement couplés, de ramener la tension aux bornes du module associé Mi(i 3) à 3,6 V.

Pour permettre l'égalisation des tensions, deux traitements peuvent être envisagés. Un premier traitement consiste à déterminer au niveau de l'élément de traitement ETi une donnée représentative de l'écart entre la tension U_{Mod} mesurée aux bornes du module associé Mi et la tension moyenne par module U_{M}, puis à adjoindre cette donnée aux signaux d'alerte transmis à l'élément d'équilibrage EEi de sorte qu'il réduise la tension aux bornes du module concerné Mi d'une valeur représentative de l'écart déterminé. Dans ce cas, l'intensité du courant dérivé (ou dévié) du module Mi, ou la durée de la dérivation, est choisie par le module d'équilibrage EEi en fonction de l'écart reçu.

Un second traitement consiste simplement à adresser à l'élément d'équilibrage EEi, à l'aide de l'élément de traitement ETi, une donnée (ou signal d'alerte) pouvant prendre deux valeurs différentes, par exemple «0» et «1» dans un fonctionnement de type numérique, selon qu'une décharge est requise ou non. Ainsi, l'une de ces valeurs (par exemple « 0 ») indique à l'élément d'équilibrage EEi qu'aucune action ne doit être entreprise, tandis que l'autre valeur (par exemple «1») est un signal d'alerte requérant la déviation du courant du module Mi. Cette déviation peut correspondre à un courant dévié d'une valeur préétablie ou à une durée de déviation préétablie. Mais, on peut aussi considérer que tant que l'élément d'équilibrage EEi reçoit un signal d'alerte («1») il procède à la décharge du générateur électrochimique Gi du module Mi associé, et interrompt cette déviation (ou «balancing») dès qu'il cesse de recevoir le signal d'alerte.

Les différents éléments d'équilibrage EEi sont préférentiellement agencés de manière à assurer l'équilibrage des modules Mi en permanence, c'est-à-dire pendant les phases de charge, de décharge et de repos. Mais, bien entendu, ils pourraient être configurés de manière à ne fonctionner que pendant l'une et/ou l'autre de ces trois phases.

L'élément d'équilibrage EEi peut être réalisé de n'importe quelle façon connue de l'homme de l'art. Plus précisément, tout moyen permettant de dériver ou consommer de l'énergie pour décharger le module Mi peut être envisagé. On pourra ainsi utiliser un dipôle comme par exemple une résistance (implantée dans le module Mi), ou une diode simple, ou encore une LED. La tension variant beaucoup dans la région du seuil bas, il est en effet facile d'obtenir un rééquilibrage efficace.

L'élément d'équilibrage EEi peut même être un élément externe au dispositif de contrôle D, dès lors qu'il reçoit ses ordres des moyens de contrôle dudit dispositif D. Par ailleurs, chaque circuit de contrôle Ci peut ne pas disposer de son propre élément d'équilibrage EEi. Dans ce cas, la fonction d'équilibrage est assurée par un module d'équilibrage couplé à chacun desdits modules Mi ainsi qu'aux moyens de traitement ETi associés.

Le dispositif de contrôle D peut être couplé à un module de gestion MG dédié à la gestion de fin de charge et de fin de décharge des différents modules Mi. Il est plus précisément couplé aux différents éléments de traitement ETi, ainsi que, préférentiellement, aux différents éléments d'équilibrage EEi, de manière à pouvoir contrôler leurs fonctionnements lorsque cela s'avère nécessaire. Cela est notamment utile lorsque l'équilibrage s'effectue pendant une décharge profonde.

Il est important de noter que, l'invention étant destinée à assurer que les différents générateurs électrochimiques Gi présentent en permanence une même tension, il suffit que le module de gestion MG contrôle un seul circuit Ci, par exemple le premier C1, pour contrôler l'état de fin de charge et de fin de décharge de toute la batterie BAT. Par exemple, dans le cas de générateurs de type Li/ion, la fin de charge peut correspondre à une tension aux bornes du premier générateur G1 égale à 4,1 V, tandis que la fin de décharge peut correspondre à une tension aux bornes du premier générateur G1 égale à 2,7 V.

Le module de gestion MG, qui ne fait pas partie de l'invention, peut être réalisé de n'importe quelle façon connue de l'homme de l'art. Il faut seulement qu'il comporte au moins des comparateurs, par exemple réalisés avec des amplis opérationnels, pour effectuer la comparaison de la tension d'un module Mi à une tension seuil.

Chaque circuit de contrôle Ci peut être vu comme un circuit électronique de type «1S». En d'autres termes, le dispositif de contrôle D selon l'invention peut être vu comme N circuits de contrôle de tension Ci, de type 1S, couplés aux modules Mi et à un module de calcul MC monté en parallèle aux bornes de la batterie BAT.

Mais, comme indiqué précédemment, le dispositif de contrôle D selon l'invention peut être constitué différemment d'un dispositif de type Nx1S. Il peut en effet être réalisé sous la forme d'un unique circuit comportant :
un module de mesure chargé de déterminer les tensions U_{Mod} aux bornes de chacun des modules Mi de la batterie BAT,
un module de calcul chargé de mesurer la tension U_{BAT} aux bornes de la batterie BAT et de déterminer une tension moyenne par module U_{M}, représentative de la tension de la batterie U_{BAT} divisée par le nombre total N de modules Mi, et
un module de traitement agencé de manière à comparer chaque tension de module U_{Mod} mesurée à la tension moyenne par module U_{M}, puis à délivrer à un module d'équilibrage EEi des signaux d'alerte représentatifs du résultat de la comparaison chaque fois que la tension d'un module U_{Mod} est supérieure à la tension moyenne U_{M}, de sorte qu'il réduise la tension aux bornes de ce module Mi objet de l'alerte (ce module d'équilibrage faisant éventuellement partie dudit dispositif de contrôle D).

L'invention offre également un procédé de contrôle de la tension d'une batterie BAT comportant au moins deux modules Mi montés en série et comprenant chacun au moins un générateur électrochimique Gi.

Celui-ci peut être notamment mis en oeuvre à l'aide du dispositif de contrôle D présenté ci-avant. Les fonctions et sous-fonctions principales et optionnelles assurées par les étapes de ce procédé étant sensiblement identiques à celles assurées par les différents moyens constituant le dispositif de contrôle D, seules seront résumées ci-après les étapes mettant en oeuvre les fonctions principales du procédé selon l'invention.

Ce procédé consiste, d'une première part, à déterminer des premières tensions aux bornes de chacun des modules Mi, d'une deuxième part, à mesurer une seconde tension aux bornes de la batterie BAT, puis à déterminer une tension moyenne par module, représentative de la seconde tension divisée par le nombre N de modules Mi, d'une troisième part, à comparer chaque première tension mesurée à la tension moyenne par module et à délivrer des signaux représentatifs du résultat d'une comparaison chaque fois qu'une première tension est supérieure à la tension moyenne, et d'une quatrième part, à réception de signaux désignant un module, à réduire la tension aux bornes du module concerné Mi.

Grâce à l'invention, on peut obtenir un équilibrage (ou « balancing ») réellement efficace des différents modules de générateurs électrochimiques de la batterie.

De plus, l'invention offre un dispositif de contrôle de tension indépendant de la puissance et de la capacité en charge et en décharge de la batterie.

En outre, l'invention offre un dispositif de contrôle de tension modulable, sans discontinuité, en fonction du nombre de modules de générateurs électrochimiques que comprend la batterie.

Enfin, l'invention offre un dispositif de contrôle de tension qui peut être facilement connecté à une batterie et déconnecté de celle-ci.

L'invention ne se limite pas aux modes de réalisation de dispositifs de contrôle et de batterie décrits ci-avant, seulement à titre d'exemple, mais elle englobe toutes les variantes que pourra envisager l'homme de l'art dans le cadre des revendications ci-après.

## Revendications

1. Dispositif de contrôle (D) de la tension d'une batterie (BAT) comportant au moins deux modules (Mi), montés en série, comprenant chacun au moins un générateur électrochimique (Gi), et couplés à des moyens d'équilibrage de tension (EEi), **caractérisé en ce qu'**il comprend des moyens de mesure (Ri,EMi) propres à déterminer des premières tensions aux bornes de chacun desdits modules (Mi), des moyens de calcul (MC) propres à mesurer une seconde tension aux bornes de ladite batterie (BAT) et à déterminer une tension moyenne par module, représentative de ladite seconde tension divisée par le nombre de modules (Mi), et des moyens de traitement (ETi) agencés pour comparer chaque première tension mesurée à ladite tension moyenne par module, puis adresser auxdits moyens d'équilibrage (EEi) des signaux représentatifs du résultat d'une comparaison chaque fois que la première tension d'un module est supérieure à la tension moyenne, de sorte qu'ils réduisent la tension aux bornes dudit module (Mi).

2. Dispositif selon la revendication 1, **caractérisé en ce que** lesdits moyens de traitement (ETi) sont agencés pour déterminer une donnée représentative de l'écart entre la première tension mesurée aux bornes d'un module (Mi) et ladite tension moyenne par module et adjoindre ladite donnée auxdits signaux, de sorte que lesdits moyens d'équilibrage (EEi) réduisent la tension aux bornes dudit module (Mi) d'une valeur représentative dudit écart déterminé.

3. Dispositif selon l'une des revendications 1 et 2, **caractérisé en ce que** ladite tension moyenne par module, délivrée par lesdits moyens de calcul (MC), est égale à la somme du rapport entre ladite seconde tension et ledit nombre de modules et d'une valeur seuil de décalage.

4. Dispositif selon l'une des revendications 1 à 3, **caractérisé en ce que** lesdits moyens de calcul (CM) comprennent un ensemble de résistances (Ri) montées en série, en nombre égal au nombre de modules (Mi), et raccordé, en parallèle, aux bornes de ladite batterie (BAT).

5. Dispositif selon la revendication 4, **caractérisé en ce que** lesdits modules étant identiques, lesdites résistances sont identiques.

6. Dispositif selon l'une des revendications 1 à 5, **caractérisé en ce que** lesdits moyens de traitement (ETi) sont agencés sous forme d'éléments de traitement associés chacun à un module (Mi) et propres chacun à comparer la première tension, mesurée aux bornes du module associé (Mi), à ladite tension moyenne par module et à délivrer des signaux représentatifs du résultat de la comparaison au moins chaque fois que ladite première tension est supérieure à ladite tension moyenne.

7. Dispositif selon l'une des revendications 1 à 6, **caractérisé en ce qu'**il comprend lesdits moyens d'équilibrage (EEi).

8. Dispositif selon la revendication 7, **caractérisé en ce que** lesdits moyens d'équilibrage (EEi) sont agencés sous forme d'éléments d'équilibrage associés chacun à un module (Mi).

9. Dispositif selon la combinaison des revendications 6 et 8, **caractérisé en ce que** l'élément de traitement (ETi), et l'élément d'équilibrage (EEi), associés à un même module (Mi), constituent ensemble un circuit de contrôle (Ci), lesdits circuits de contrôle (Ci) associés aux différents modules (Mi) étant indépendants les uns des autres.

10. Dispositif selon l'une des revendications 7 à 9, **caractérisé en ce que** lesdits moyens d'équilibrage (EEi) sont agencés pour assurer l'équilibrage desdits modules (Mi) en phase de charge et/ou en phase de décharge et/ou en phase de repos.

11. Batterie (BAT) comportant au moins deux modules (Mi) montés en série et comprenant chacun au moins un générateur électrochimique (Gi), **caractérisée en ce qu'**elle comprend un dispositif de contrôle (D) selon l'une des revendications précédentes.

12. Batterie selon la revendication 11, **caractérisée en ce que** chaque générateur électrochimique (Gi) est choisi dans un groupe comprenant au moins les générateurs au lithium, et en particulier les générateurs lithium / ion (Li/Ion), les générateurs argent / zinc et les générateurs à polymères.

13. Procédé de contrôle de la tension d'une batterie (BAT) comportant au moins deux modules (Mi), montés en série et comprenant chacun au moins un générateur électrochimique (Gi), **caractérisé en ce qu'**il consiste i) à déterminer des premières tensions aux bornes de chacun desdits modules (Mi), ii) à mesurer une seconde tension aux bornes de ladite batterie (BAT), puis à déterminer une tension moyenne par module, représentative de ladite seconde tension divisée par le nombre de modules (Mi), iii) à comparer chaque première tension mesurée à ladite tension moyenne par module et à délivrer des signaux représentatifs du résultat d'une comparaison chaque fois que la première tension d'un module est supérieure à la tension moyenne, et iv) à réception de signaux désignant un module (Mi), à réduire la tension aux bornes dudit module (Mi).

14. Procédé selon la revendication 13, **caractérisé en ce que** l'on détermine une donnée représentative de l'écart entre une première tension mesurée et ladite tension moyenne par module, et on adjoint ladite donnée auxdits signaux, et, à réception desdits signaux désignant un module (Mi), on réduit la tension aux bornes du module concerné (Mi) d'une valeur représentative dudit écart déterminé.
